(19) Europäisches Patentamt
European Patent Office
Office européen des brevets

(11) **EP 3 449 264 B1**

(12) **EUROPÄISCHE PATENTSCHRIFT**

(45) Veröffentlichungstag und Bekanntmachung des Hinweises auf die Patenterteilung:
**01.03.2023 Patentblatt 2023/09**

(21) Anmeldenummer: **17712948.3**

(22) Anmeldetag: **21.03.2017**

(51) Internationale Patentklassifikation (IPC):
**G01R 15/14** *(2006.01)*    **G01R 35/00** *(2006.01)*
**G01R 1/20** *(2006.01)*

(52) Gemeinsame Patentklassifikation (CPC):
**G01R 1/203; G01R 15/146; G01R 35/005**

(86) Internationale Anmeldenummer:
**PCT/EP2017/056610**

(87) Internationale Veröffentlichungsnummer:
**WO 2017/186410 (02.11.2017 Gazette 2017/44)**

(54) **VERFAHREN ZUM BESTIMMEN EINES LASTSTROMS UND BATTERIESENSOR**

METHOD FOR DETERMINING A LOAD CURRENT AND BATTERY SENSOR

PROCÉDÉ POUR DÉTERMINER UN COURANT DE CHARGE ET CAPTEUR DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.04.2016 DE 102016206958**

(43) Veröffentlichungstag der Anmeldung:
**06.03.2019 Patentblatt 2019/10**

(73) Patentinhaber: **Continental Automotive Technologies GmbH**
**30165 Hannover (DE)**

(72) Erfinder:
• **AUMER, Andreas**
**93133 Burglengenfeld (DE)**

• **GRAF, Hans-Michael**
**93049 Regensburg (DE)**
• **SCHRAMME, Martin**
**86343 Königsbrunn (DE)**

(74) Vertreter: **Continental Corporation**
**c/o Continental Teves AG & Co. OHG**
**Intellectual Property**
**Guerickestraße 7**
**60488 Frankfurt a. Main (DE)**

(56) Entgegenhaltungen:
**JP-A- S62 168 067    US-A1- 2014 191 768**

EP 3 449 264 B1

**Beschreibung**

Die Erfindung betrifft ein Verfahren zum Bestimmen eines durch eine Messwiderstandsgruppe fließenden Laststroms.

Ein solches Verfahren kann insbesondere zur Bestimmung des Batteriezustands einer Batterie, beispielsweise einer Autobatterie, verwendet werden. Zur Bestimmung eines Batteriezustands ist es typischerweise erforderlich, den Batteriestrom zu messen. Dieser kann auch als Laststrom bezeichnet werden. Hierzu kommen bei Ausführungen gemäß dem Stand der Technik typischerweise hochgenaue Widerstände oder Sensoren zur Messung der magnetischen Feldstärke zum Einsatz. Nachteilig an den bisherigen Ausführungen sind insbesondere die hohen Kosten, insbesondere zur Erstellung von Widerstandsmaterialien, welche in einem üblichen Temperaturbereich von beispielsweise -40 °C bis 105 °C mehr oder weniger konstante Widerstandswerte aufweisen. Ein Beispiel eines solchen Materials ist eine Kupfer-Nickel-Mangan-Legierung, beispielsweise Manganin.

Eine Strommessung kann beispielsweise zum Einsatz in Batteriesensoren zur nachgelagerten Berechnung von physikalischen Größen einer Batterie vorgesehen sein.

Seit einiger Zeit gibt es Ansätze, einen hochpräzisen Widerstand als Messwiderstand, auch als Shunt-Widerstand bezeichnet, durch kostengünstigere Bauteile zu ersetzen. Eine Möglichkeit ist es, einen Shunt-Widerstand über die Lebensdauer des Batteriesensors immer wieder nachzukalibrieren wie z.B. im US2014191768 zu sehen ist.

Es hat sich jedoch herausgestellt, dass eine ständige Nachkalibrierung auch während der gleichzeitigen Messung der im Kraftfahrzeug auftretenden hohen und zeitlich stark veränderlichen Ströme unter den herrschenden Randbedingungen, insbesondere eines erwünschten niedrigen Stromverbrauchs des Sensors, schwierig ist, da der zum Kalibrieren anzulegende Kalibrierstrom klein gewählt werden soll und nur kurzzeitig anliegen soll.

Es ist deshalb eine Aufgabe der Erfindung, ein Verfahren zum Bestimmen eines Laststroms bereitzustellen, welches im Vergleich zu bekannten Ausführungen alternativ, beispielsweise besser und/oder kostengünstiger auszuführen ist. Es ist des Weiteren eine Aufgabe der Erfindung einen zugehörigen Batteriesensor bereitzustellen.

Dies wird erfindungsgemäß durch ein Verfahren nach Anspruch 1 und einen Batteriesensor nach Anspruch 13 erreicht. Vorteilhafte Ausführungen können beispielsweise den jeweiligen Unteransprüchen entnommen werden. Der Inhalt der Ansprüche wird durch ausdrückliche Inbezugnahme zum Inhalt der Beschreibung gemacht.

Die Erfindung betrifft ein Verfahren zum Bestimmen eines durch eine Messwiderstandsgruppe fließenden Laststroms. Die Messwiderstandsgruppe weist eine Anzahl von Zweigen auf, und jeder Zweig weist zumindest einen jeweiligen ersten Messwiderstand und einen jeweiligen zweiten Messwiderstand auf. Das Verfahren weist für jeden der Zweige folgende Schritte auf:

- Messen einer ersten Messspannung, welche über dem ersten Messwiderstand abfällt, und einer zweiten Messspannung, welche über dem zweiten Messwiderstand abfällt,
- Berechnen eines ersten Betriebsparameters basierend auf der ersten Messspannung und der zweiten Messspannung,
- Berechnen des Laststroms basierend zumindest auf der zweiten Messspannung und einem zweiten Betriebsparameter,
- wobei das Verfahren ausschließlich während jeweiliger Kalibrierzeiträume folgende Schritte aufweist:
- Leiten eines Kalibrierstroms in dem Zweig der Messwiderstandsgruppe, wobei sich der Kalibrierstrom in einen durch den ersten Messwiderstand fließenden ersten Kalibrierteilstrom und einen durch den zweiten Messwiderstand fließenden zweiten Kalibrierteilstrom aufteilt, und
- Messen einer ersten Kalibrierspannung, welche bei fließendem Kalibrierstrom und Laststrom über dem ersten Messwiderstand abfällt, und einer zweiten Kalibrierspannung, welche bei fließendem Kalibrierstrom und Laststrom über dem zweiten Messwiderstand abfällt,
- wobei basierend zumindest auf der ersten Kalibrierspannung, der zweiten Kalibrierspannung, dem ersten Betriebsparameter und einer Stromstärke des Kalibrierstroms der zweite Betriebsparameter berechnet wird.

Mittels des erfindungsgemäßen Verfahrens ist es vorteilhaft möglich, einen Laststrom zu bestimmen. Hierzu kann ein ursprünglich nur aus einem einzigen Widerstand bestehender Messwiderstand verallgemeinert werden zu einer Messwiderstandsgruppe, welche mindestens einen Zweig mit mindestens zwei Messwiderständen aufweist. Es sei verstanden, dass jede beliebige Anzahl von Zweigen verwendet werden kann, also beispielsweise ein Zweig, zwei Zweige, drei Zweige oder mehr Zweige.

Bei den Lastströmen kann es sich insbesondere jeweils um diejenigen Teile eines Gesamtlaststroms handeln, welche durch den jeweiligen Zweig fließen.

Es sei verstanden, dass eine über einem jeweiligen Messwiderstand abfallende Spannung, also Messspannung bzw. Kalibrierspannung, grundsätzlich sowohl unmittelbar über dem jeweiligen Messwiderstand gemessen werden kann oder auch derart gemessen werden kann, dass eine Gesamtspannung über mehrere Widerstände, beispielsweise zwei Widerstände, gemessen wird und eine über einem anderen Widerstand abfallende Spannung davon subtrahiert wird. Diese Ausführungen sind äquivalent im Sinne dieser Anmeldung und sollen beide entsprechend von den hier verwendeten Formulierungen umfasst sein.

Es sei verstanden, dass beim Schritt des Berechnens des Laststroms basierend zumindest auf der zweiten Messspannung und einem zweiten Betriebsparameter alternativ zur zweiten Messspannung auch die erste Messspannung oder eine Summe aus erster Messspannung und zweiter Messspannung verwendet werden kann. Derartige Varianten sind als äquivalent zu betrachten.

Bei mehreren Zweigen werden die jeweiligen berechneten Lastströme der Zweige bevorzugt zu einem Gesamtlaststrom addiert.

Zu den Details der Vorgehensweise sei auf die unten stehenden Ausführungen verwiesen.

Bevorzugt ist bezogen auf eine Stromrichtung des Laststroms der erste Kalibrierstrom unterschiedlich, insbesondere gegengleich zum zweiten Kalibrierstrom. Dies führt zu einer vorteilhaften Lösbarkeit von Gleichungssystemen, welche weiter unten näher beschrieben werden.

Gemäß einer Ausführung ist der erste Kalibrierteilstrom null. Dies kann eine Stromquelle einsparen und eine besonders einfache Auswertung ermöglichen.

Es sei verstanden, dass solche Ausführungen, in welchen also beispielsweise ein Kalibrierteilstrom null ist, von der obenstehenden Offenbarung umfasst werden.

Bevorzugt entspricht der zweite Betriebsparameter einem Produkt aus einem Widerstandswert des zweiten Messwiderstands und einem Verstärkungsfaktor eines die zweite Messspannung messenden Spannungsmessers.

Der zweite Betriebsparameter kann insbesondere als Differenz zwischen einem ersten Bruch und einem zweiten Bruch berechnet werden, wobei im Zähler des ersten Bruchs die zweite Referenzspannung steht, wobei im Nenner des ersten Bruchs die Stromstärke des Kalibrierstroms steht, wobei im Zähler des zweiten Bruchs die erste Referenzspannung steht, und wobei im Nenner des zweiten Bruchs ein Produkt aus dem ersten Betriebsparameter und der Stromstärke des Kalibrierstroms steht. Dies erlaubt eine vorteilhafte Berechnung des zweiten Betriebsparameters insbesondere bei der oben angegebenen Bedeutung. Zu den mathematischen Hintergründen sei auf die untenstehende Ausführung verwiesen.

Es sei verstanden, dass bei in dieser Anmeldung angegebenen Gleichungen oder Formeln, seien sie in Textform oder als Formel angegeben, grundsätzlich auch gewisse Umformungen, insbesondere triviale Umformungen, als äquivalent angesehen werden und nicht aus dem Schutzbereich herausführen. So kann beispielsweise eine Gleichung mit einer Konstanten multipliziert werden.

Der erste Betriebsparameter entspricht vorzugsweise einem Verhältnis zwischen

-  einem Produkt aus Widerstandswert des zweiten Messwiderstands und Verstärkungsfaktor eines die zweite Messspannung messenden Spannungsmessers und
-  einem Produkt aus Widerstandswert des ersten Messwiderstands und Verstärkungsfaktor eines die erste Messspannung messenden Spannungsmessers.

Der erste Betriebsparameter wird dabei vorzugsweise durch Division der ersten Messspannung durch die zweite Messspannung oder durch Regressionsanalyse basierend auf der ersten Messspannung und der zweiten Messspannung berechnet. Dies erlaubt insbesondere eine vorteilhafte Berechnung des ersten Betriebsparameters bei der oben angegebenen Bedeutung.

Bevorzugt wird der erste Betriebsparameter außerhalb von Kalibrierzeiträumen berechnet, insbesondere wenn auch die Messspannungen gemessen werden.

Gemäß einer Ausführung wird der Laststrom während jeweiliger Kalibrierzeiträume durch Extrapolation von Lastströmen aus Zeiten außerhalb von Kalibrierzeiträumen berechnet. Dies trägt der Tatsache Rechnung, dass es je nach Ausführung schwierig oder gar unmöglich sein kann, den Laststrom während eines Kalibrierzeitraums, also bei überlagertem Kalibrierstrom, exakt zu berechnen.

Gemäß einer Ausführung ist der erste Kalibrierteilstrom null, und der Laststrom wird während jeweiliger Kalibrierzeiträume basierend auf der zweiten Kalibrierspannung, dem zweiten Betriebsparameter und der Stromstärke des Kalibrierstroms berechnet. Dies trägt insbesondere der Tatsache Rechnung, dass, insbesondere wenn der erste Kalibrierteilstrom null ist, eine exakte Berechnung des Laststroms auch während eines Kalibrierzeitraums möglich ist.

Insbesondere in diesem Fall kann der Laststrom auf zwei verschiedene beispielhafte Weisen bestimmt werden. Zum ersten kann er aus der zweiten Kalibrierspannung, dividiert durch den zweiten Betriebsparameter, minus dem bekannten Kalibrierstrom berechnet werden, zum anderen kann er aus der ersten Kalibrierspannung, dividiert durch das Produkt aus dem ersten und dem zweiten Betriebsparameter, berechnet werden.

Vorteilhafterweise wird das Endergebnis als Mittelwert der beiden eben genannten Methoden ausgegeben bzw. berechnet.

Gemäß einer Ausführung wird der Laststrom außerhalb von Kalibrierzeiträumen durch Division der zweiten Messspannung durch den zweiten Betriebsparameter berechnet.

Gemäß einer Ausführung wird der Laststrom während Kalibrierzeiträumen durch Division der zweiten Kalibrierspannung durch den zweiten Betriebsparameter abzüglich eines Korrekturwerts berechnet, wobei der Korrekturwert vorzugsweise die Stromstärke des Kalibrierstroms ist, insbesondere wenn der erste Kalibrierteilstrom null ist.

Man könnte auch einen Schätzwert für die Aufteilung des Kalibrierstroms verwenden. Aufgrund der typischerweise bekannten nominalen Widerstandswerte des ersten Messwiderstands und des zweiten Messwiderstands ist es typischerweise abschätzbar, wie sich der Strom aufteilen wird. Solange der Kalibrierstrom klein ist im Vergleich zum Laststrom, ergibt dies üblicherweise nur einen kleinen Fehler.

Die Stromstärke des Kalibrierstroms kann insbesondere basierend auf einem gemessenen Spannungsabfall an einem Referenzwiderstand ermittelt werden, wobei dieser Referenzwiderstand insbesondere ein temperatur- und/oder langzeitstabiler Referenzwiderstand ist. Dieser weist einen bekannten Widerstand auf.

Es sei erwähnt, dass damit typischerweise der Kalibrierstrom zunächst einmal nur in der Summe gemessen wird, d.h. ohne Kenntnis der beiden Kalibrierteilströme. Um den Kalibrierstrom zu messen, sind zahlreiche Möglichkeiten denkbar. Die eben erwähnte Spannungsmessung über einem Referenzwiderstand ist ein Beispiel davon. Eine andere Möglichkeit wäre es, den Kalibrierstrom von einer präzisen Stromquelle zu beziehen.

Gemäß einer Weiterbildung wird basierend auf der Stromstärke des Referenzwiderstands ein Fehlerwert für den Laststrom berechnet. Damit kann die Zuverlässigkeit des ermittelten Laststroms abgeschätzt werden.

Die Erfindung betrifft des Weiteren einen Batteriesensor.

Der Batteriesensor weist eine Messwiderstandsgruppe auf, wobei die Messwiderstandsgruppe eine Anzahl von Zweigen aufweist und jeder Zweig zumindest einen jeweiligen ersten Messwiderstand und einen jeweiligen zweiten Messwiderstand aufweist. Der Batteriesensor weist zumindest einen ersten Spannungsmesser und einen zweiten Spannungsmesser auf, wobei der erste Spannungsmesser zur Messung einer über dem ersten Messwiderstand abfallenden Spannung konfiguriert ist und der zweite Spannungsmesser zur Messung einer über dem zweiten Messwiderstand abfallenden Spannung konfiguriert ist. Der Batteriesensor weist des Weiteren zumindest eine Kalibrierstromquelle auf, welche zum Durchleiten eines Kalibrierstroms durch die Messwiderstandsgruppe konfiguriert ist. Der Batteriesensor weist des Weiteren eine elektronische Steuerungsvorrichtung auf, welche dazu konfiguriert ist, ein erfindungsgemäßes Verfahren auszuführen. Hinsichtlich des Verfahrens kann auf alle beschriebenen Ausführungen und Varianten zurückgegriffen werden.

Mittels des erfindungsgemäßen Batteriesensors kann das erfindungsgemäße Verfahren besonders vorteilhaft ausgeführt werden. Zu den damit verbundenen Vorteilen und Varianten sei auf die obige Beschreibung des Verfahrens verwiesen.

Die elektronische Steuerungsvorrichtung kann insbesondere Prozessormittel und Speichermittel aufweisen, wobei in den Speichermitteln Programmcode gespeichert ist, bei dessen Ausführung die Prozessormittel ein erfindungsgemäßes Verfahren ausführen bzw. sich entsprechend verhalten.

Gemäß einer Ausführung weist die Messwiderstandsgruppe einen einzigen Zweig auf. Dies entspricht einer einfachen Ausführung.

Gemäß einer Ausführung weist die Messwiderstandsgruppe eine Mehrzahl von Zweigen auf. Damit kann beispielsweise unterschiedlichen Stromstärken Rechnung getragen werden.

Es kann auch eine Anzahl von Multiplexern vorgesehen sein, um eine Spannungsmessung und/oder ein Durchleiten des Kalibrierstroms einem bestimmten Zweig zuzuordnen. Damit können Messinstrumente bzw. Stromquellen für unterschiedliche Zweige verwendet werden, was Aufwand einspart.

Die Messwiderstandsgruppe kann eine Mehrzahl von Zweigen aufweisen. Der Laststrom wird in diesem Fall bevorzugt summiert über alle Zweige berechnet. Dabei kann von einem Gesamtlaststrom gesprochen werden, welcher sich durch Summation über die jeweiligen Lastströme der Zweige ergibt.

Die Erfindung betrifft des Weiteren ein nichtflüchtiges computerlesbares Speichermedium, welches Programmcode enthält, bei dessen Ausführung ein Prozessor ein erfindungsgemäßes Verfahren ausführt. Dabei kann hinsichtlich des Verfahrens auf alle beschriebenen Ausführungen und Varianten zurückgegriffen werden.

Nachfolgend werden weitere Erklärungen zur Erfindung gegeben, wobei dies zum einen der Erklärung der Funktion dient und zum anderen die hierin beschriebenen Merkmale auch beliebig mit anderswo beschriebenen Merkmalen kombiniert werden können. Ebenso können sie untereinander kombiniert werden und können für sich oder in Kombination erfindungswesentliche Aspekte darstellen.

Die Bestimmung eines zu messenden Laststroms Iload erfolgt über eine Widerstandsgruppe, durch welche der Laststrom fließt. Die Widerstandsgruppe weist mindestens einen ersten Messwiderstand R1 und einen zweiten Messwiderstand R2 auf, welche zueinander in Reihe geschaltet sind. Parallel zu diesen in Reihe geschalteten Teilwiderständen können weitere in Reihe geschaltete Messwiderstände R3, R4,..., Rn-1, Rn geschaltet werden.

In dieses Widerstandsnetzwerk bzw. diese Messwiderstandsgruppe wird/werden zeitweise zusätzlich zum Laststrom ein Kalibrierstrom oder mehrere Kalibrierströme eingespeist, so dass ein Kalibrierstrom oder ein Teil des Kalibrierstroms oder ein Teil der Kalibrierströme zusammen mit dem Laststrom oder einem Teil des Laststroms über einen oder mehrere dieser Messwiderstände fließt. Die Messwiderstände können als Teilwiderstände der Messwiderstandsgruppe angesehen werden.

Dabei wird der von der Summe der über einen Messwiderstand fließenden Ströme verursachte Spannungsabfall über einen oder mehrere Teilwiderstände des Widerstandsnetzwerks gemessen.

Es können nunmehr die Punkte, an denen der/die Kalibrierströme in die Messwiderstandsgruppe eingespeist werden, und die Punkte, über welche die Spannungsmessungen an den stromdurchflossenen Messwiderständen durchgeführt werden, so gewählt, dass sich ein lösbares Gleichungssystem ergibt:

$$U_m = \left(I_{load,i} + I_{ref,m}\right) * R_m * g_m$$

$$U_n = \left(I_{load,i} + I_{ref,n}\right) * R_n * g_n$$

Dabei sind

- $U_m$, $U_n$ die gemessenen Kalibrierpannungen über je einen oder mehrere Messwiderstände mit Nummer m, n,

- $R_m$, $R_n$ die (unbekannten) Messwiderstände, über die die Kalibrierspannungen $U_m$, $U_n$ gemessen werden. Die Messwiderstände können ihrerseits wieder aus weiteren, in Reihe oder parallel geschalteten Messwiderständen bestehen,

- $g_m$, $g_n$ die (fehlerbehafteten) Verstärkungsfaktoren der Messgeräte für die Spannungen $U_m$, $U_n$,

- $I_{load,i}$ der zu messende Laststrom oder ein Teil dieses Laststroms, der über die Messwiderstände der Messwiderstandsgruppe fließt, über die die Kalibrierspannungen $U_m$, $U_n$ gemessen werden,

- $I_{ref,m}$ und $I_{ref,n}$ angelegte Kalibrierteilströme, die über die Messwiderstände $R_m$, $R_n$ der Messwiderstandsgruppe fließen, über welchen die Kalibrierpannungen $U_m$, $U_n$ gemessen werden, wobei $I_{ref,m}$ und $I_{ref,n}$ in unterschiedliche Richtungen, bezogen auf $I_{load,i}$ fließen.

Insbesondere werden die Kalibrierteilstöme bzw. wird der Kalibrierstrom periodisch angelegt, beispielsweise mit einer Periodendauer zwischen 10 ms und 100 ms für eine Dauer aus einer Zeitspanne zwischen 10 μs und 100 ps. Damit ergeben sich Zeiten, in denen Kalibrierströme oder Teile davon durch Messwiderstände der Messwiderstandsgruppe fließen, also Kalibrierzeiträume, und Zeiten, in denen keine Kalibrierströme durch die Messwiderstandsgruppe fließen. Zu diesen Zeiten, also außerhalb von Kalibrierzeiträumen, vereinfachen sich wenigstens ein Teil der Gleichungen des Gleichungssystems zu

$$U_m = I_{load,i} * R_m * g_m$$

$$U_n = I_{load,i} * R_n * g_n$$

$U_m$, $U_n$ bezeichnen dabei Messspannungen, also außerhalb von Kalibrierzeiträumen gemessene Spannungen.
Alternativ können zu den Zeiten, in denen Kalibrierströme fließen, also innerhalb von Kalibrierzeiträumen, zeitlich veränderliche Kalibrierströme angelegt werden.
Zu den Zeiten, in denen keine Kalibrierströme durch das Netzwerk fließen, werden vorteilhaft Beziehungen $\alpha_{mn}$ zwischen einzelnen Gleichungen des Gleichungssystems (bzw. zwischen gemessenen Spannungen $U_i$) gebildet (beispielsweise in einem Microkontroller, der Bestandteil einer Strommessvorrichtung oder mit dieser verbunden sein kann):

$$U_m = \alpha_{mn} * U_n$$

bzw.

$$U_m = \alpha_{mn} * I_{Load,i} * R_n * g_n$$

Beispielsweise können zu jeweils gleichen Zeiten t gemessene Spannungs-Wertepaare $U_n(t)$, $U_m(t)$ gespeichert werden. Diese gespeicherten Wertepaare können im Microcontroller mittels linearer Regression ausgewertet werden, um die Beziehung $\alpha_{mn}$ zu ermitteln. Dies entspricht einer Berechnungsvorschrift für den oben erwähnten ersten Betriebsparameter.

Vorteilhaft kann nun bei eingeschalteten Kalibrierströmen durch Messung der Spannungen $U_m$, $U_n$

$$U_m = \alpha_{mn} * \left(I_{load,i} + I_{ref,m}\right) * R_n * g_n$$

$$U_n = \left(I_{Load,i} + I_{ref,n}\right) * R_n * g_n$$

der zu messende Teil des Laststroms wie folgt bestimmt werden:

$$\frac{U_m}{\alpha_{mn} * R_n * g_n} = I_{load,i} + I_{ref,m}$$

$$\frac{U_n}{R_n * g_n} = I_{load,i} + I_{ref,n}$$

$$\frac{U_n}{R_n * g_n} - \frac{U_m}{\alpha_{mn} * R_n * g_n} = I_{ref,n} - I_{ref,m}$$

$$\frac{U_n}{\left(I_{ref,n} - I_{ref,m}\right)} - \frac{U_m}{\alpha_{mn} * \left(I_{ref,n} - I_{ref,m}\right)} = R_n * g_n$$

$$I_{load,i} = \frac{U_n}{R_n * g_n} - I_{ref,n}$$

Die vorletzte Formel gibt eine Berechnungsvorschrift für den zweiten Betriebsparameter an.

In Zeiten, zu welchen kein Kalibrierstrom anliegt, gilt $I_{ref,m}$ = 0 und $I_{ref,n}$ = 0 und es kann die letzte Gleichung zur Bestimmung des zu messenden Laststroms $I_{load}$ benutzt werden.

Mit bekanntem $R_n$, $g_n$, alpha$_{nm}$ kann vorteilhafterweise folgende Gleichung zur Bestimmung von $I_{load}$ benutzt werden:

$$I_{load,i} = \frac{1}{2} * \left(\frac{U_m}{R_m * g_m} + \frac{U_n}{R_n * g_n} - I_{ref,m} - I_{ref,n}\right)$$

Aus der Summe beider Gleichungen lässt sich $I_{load}$ näherungsweise auch für die Zeiten zurückrechnen, in denen der Kalibrierstrom angeschaltet ist:

$$I_{load,i} = \frac{1}{2} * \left(\frac{U_m}{R_m * g_m} + \frac{U_n}{R_n * g_n} - I_{ref,m} - I_{ref,n}\right) = \frac{1}{2} * \left(\frac{U_m}{R_m * g_m} + \frac{U_n}{R_n * g_n} \pm \left\|I_{ref,m}\right| - \left|I_{ref,n}\right\|\right)$$

Dabei entsteht ein Fehler insbesondere dann, wenn sich die Ströme $I_{ref,m}$ und $I_{ref,n}$ stark unterscheiden.

Der Wert $I_{ref,m}$ - $I_{ref,n}$ ist dabei bekannt, er entspricht dem Kalibrierstrom, also der Summe der Kalibrierteilströme.

Hierbei sind die unterschiedlichen Vorzeichen berücksichtigt.

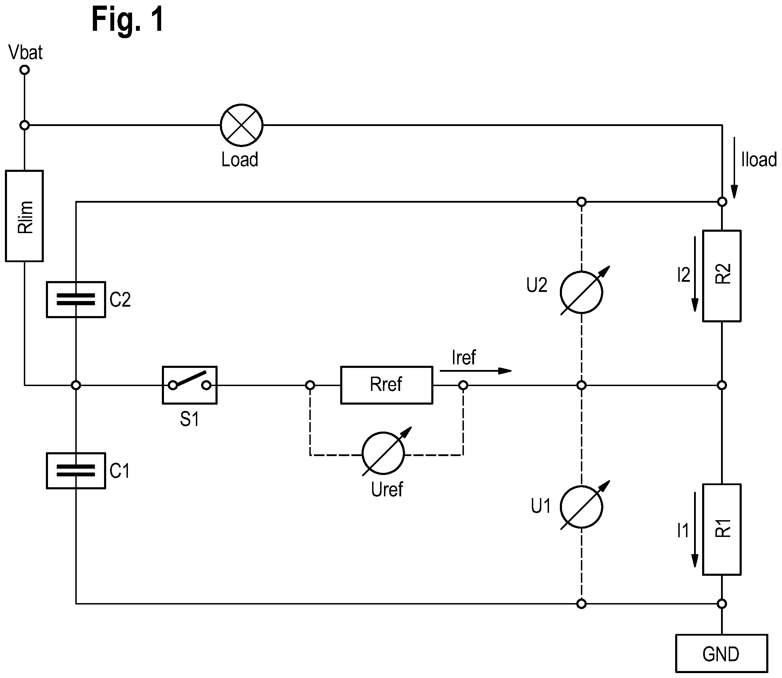

In dem Fall der weiter unten näher beschriebenen Figur 1 kann die Messung von $I_{load}$ für den Moment des Kalibriervorgangs unterbrochen werden. Beispielsweise kann der Messwert von $I_{load}$ für den Kalibrierzeitpunkt aus Mittelwerten von Messwerten vor dem Kalibrierzeitpunkt und Messwerten nach dem Kalibrierzeitpunkt gebildet werden. Alternativ kann eine Entscheidung getroffen werden, ob der fehlerbehaftete Messwert benutzt oder ein Ersatzwert gebildet wird. Die Entscheidung kann z. B. auf Basis eines aktuellen Wertes des "Symmetriefaktors" $\alpha_{mn}$ im Vergleich zu früheren Werten von $\alpha_{mn}$ getroffen werden. Die Entscheidung kann aber auch davon abhängig gemacht werden, wie groß das Verhältnis des Fehlers im Vergleich zum anliegenden Laststrom ist.

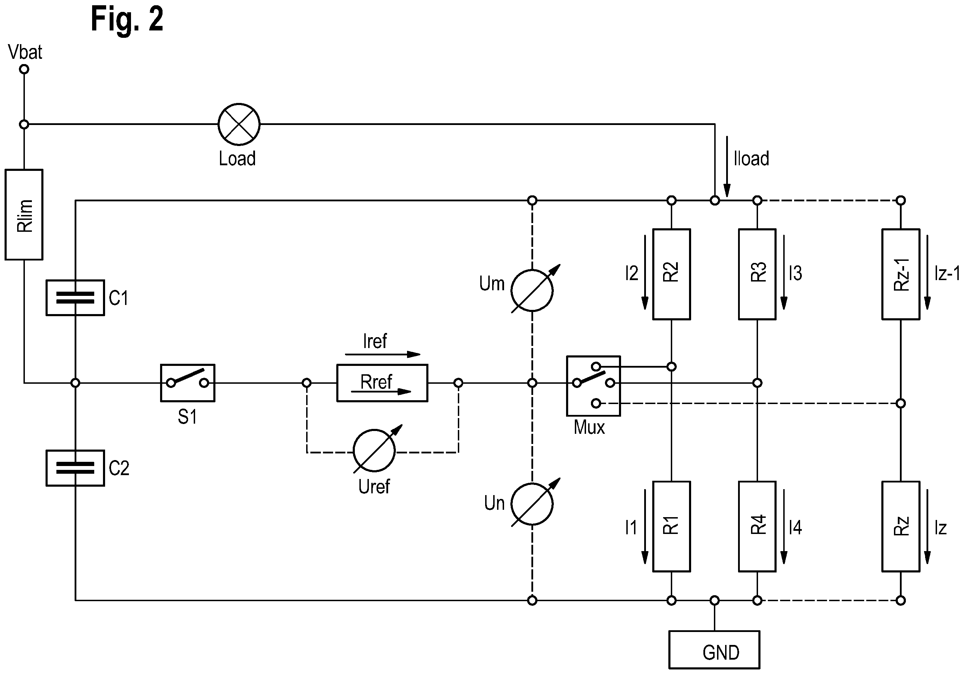

Hier zeigt sich ein Vorteil der Ausgestaltung der weiter unten beschriebenen Figur 2. Da zu einem Kalibrierzeitpunkt jeweils nur ein Zweig des Widerstandsnetzwerks mit dem Kalibrierstrom beaufschlagt wird, wird der durch $\pm\|I_{ref,m}\text{-}|I_{ref,n}\|$ verursachte relative Fehler im Verhältnis der Summe der durch alle Zweige fließenden Ströme kleiner. Für die gerade nicht kalibrierten Zweige kann der jeweilig anliegende Laststrom exakt berechnet werden, da die Summe von $U_n$ und $U_m$ zu jedem Zeitpunkt für alle Zweige gleich ist, unabhängig davon ob gerade einer der Zweige kalibriert wird oder nicht.

Die Messwiderstände $R_1$, $R_2$, ..., $R_{z-1}$, $R_z$ und die Vorrichtungen zur Messung der Spannungen $U_n$, $U_m$ können nahezu beliebig große Toleranzen bzw. Abweichungen vom Sollwert haben. Auch der Wert des Kalibrierstroms spielt keine entscheidende Rolle.

Vorteilhaft sind lediglich folgende Voraussetzungen erfüllt:

Erstens: Das Verhältnis $\alpha_{mn}$ von je zwei Produkten $R_n{}^*g_n$, $R_m{}^*g_m$ von Messwiderständen $R_n$ und $R_m$ und Verstärkungsfaktoren $g_n$, $g_m$ zueinander soll über einen gewissen Zeitraum im Wesentlichen stabil sein. Dieser gewisse Zeitraum soll deutlich länger sein als die Periodendauer, mit der die periodisch angelegten Kalibrierströme zu- und abgeschaltet werden bzw. periodisch verändert werden.

Zweitens: Der Wert des Kalibrierstroms $I_{ref} = I_{ref,n} - I_{ref,m} = |I_{ref,n}| + |I_{ref,m}|$ soll zu mindestens einem Zeitpunkt, zu dem $U_n$ und $U_m$ bei angelegtem Kalibrierstrom gemessen werden, genau bekannt sein.

Es sei nun darauf hingewiesen, dass

1) der Spannungsabfall in einem Messwiderstand erhöht, der andere reduziert wird, und

2) aus der Differenz beider Messspannungen der Widerstand berechnet wird.

Hierdurch ist eine zeitaktuelle Messung des Widerstandes möglich. Dieser muss daher nicht dauerhaft konstant sein. Kostengünstigere Materialien können zum Einsatz kommen.

Durch die beschriebene Anordnung bzw. das beschriebene Verfahren ist es möglich, praktisch ohne Vorkenntnis des Widerstandsnetzwerks bzw. der Messwiderstandsgruppe und der relativen Genauigkeit der Messgeräte, mit denen die Spannungen gemessen werden, den Laststrom zu bestimmen. Dadurch kann trotz des kostengünstigeren Materials sogar eine höhere Genauigkeit der Strommessung erreicht werden, als bei Ausführungen gemäß dem Stand der Technik. Bisher geht nämlich im Wesentlichen sowohl die Toleranz des Widerstandswerts des Messwiderstands als auch die Toleranz der Spannungs-Messvorrichtung für den Spannungsabfall in die Toleranz des gemessenen Stromwerts ein.

Mit der beschriebenen Vorrichtung bzw. Anordnung ist typischerweise lediglich eine genaue Kenntnis von $I_{ref}$ zu einem Zeitpunkt erforderlich. Zudem werden praktisch keine Anforderungen an die Qualität der Stromquelle für $I_{ref}$ gestellt. Lediglich eine genaue Messung von $I_{ref}$ ist typischerweise nötig. Dies ist beispielsweise mit einem entsprechend genauen Referenzwiderstand $R_{ref}$ und einer genauen Messung des Spannungsabfalls über $R_{ref}$ einfach zu erreichen. $R_{ref}$ kann nämlich, anders als der Messwiderstand für den Laststrom, einen hohen Widerstand von z.B. 1 Ohm haben, der nur für kleine Referenzströme und nicht für hohe Lastströme ausgelegt zu werden braucht. Durch den entsprechend hoch gewählten Wert von $R_{ref}$ kann auch der Spannungsabfall $I_{ref} * R_{ref}$ bequem gemessen werden, da z. B. kein aufwändiger Verstärker erforderlich ist.

Es sei verstanden, dass es sich bei dem ersten Betriebsparameter insbesondere um $\text{alpha}_{nm}$ handelt, und es sich bei dem zweiten Betriebsparameter insbesondere um das Produkt aus Widerstand und Verstärkungsfaktor handelt.

Weitere Merkmale und Vorteile wird der Fachmann den nachfolgend mit Bezug auf die beigefügte Zeichnung beschriebenen Ausführungsbeispielen entnehmen. Dabei zeigen:

Figur 1: eine Messwiderstandsgruppe mit Beschaltung gemäß einem ersten Ausführungsbeispiel,
Figur 2: eine Messwiderstandsgruppe mit Beschaltung gemäß einem zweiten Ausführungsbeispiel,
Figur 3: eine Messwiderstandsgruppe mit Beschaltung gemäß einem dritten Ausführungsbeispiel,
Figur 4: eine Messwiderstandsgruppe mit Beschaltung gemäß einem vierten Ausführungsbeispiel, und

Figur 5: eine Messwiderstandsgruppe mit Beschaltung gemäß einem fünften Ausführungsbeispiel.

Figur 1 zeigt eine Messwiderstandsgruppe mit Beschaltung gemäß einem ersten Ausführungsbeispiel, mit welcher sich auch das erfindungsgemäße Verfahren vorteilhaft durchführen lässt.

Die Messwiderstandsgruppe weist einen ersten Messwiderstand R1 und einen zweiten Messwiderstand R2 auf, über welche ein zeitlich veränderlicher Laststrom Iload geleitet wird. Dieser Laststrom Iload stammt zunächst aus einer Batterie, welche spannungsmäßig als Vbat in Figur 1 eingezeichnet ist. Der Laststrom Iload fließt auch über eine allgemein als Load bezeichnet Last, welche hier lediglich schematisch dargestellt ist und typische elektrische Komponenten eines Kraftfahrzeugs wie beispielsweise einen Anlasser, ein Fahrzeuglicht oder elektronische Komponenten sowie auch einen Generator beinhalten kann.

Über dem ersten Messwiderstand R1 ist ein erster Spannungsmesser U1 angeordnet. Über dem zweiten Messwiderstand R2 ist ein zweiter Spannungsmesser U2 angeordnet. Diese sind dazu ausgebildet, jeweilige Spannungen über den beiden Messwiderständen R1, R2 bei jeweils durchfließendem Strom I1, I2 zu messen.

Als Stromquellen für einen Kalibrierstrom Iref dienen ein erster Kondensator C1 und ein zweiter Kondensator C2, welche über einen Vorwiderstand Rlim direkt aus der Fahrzeugbatterie geladen werden. Über den Verbraucher Load wird der Laststrom Iload aus der Batterie Vbat erzeugt, der über das Widerstandsnetzwerk der Messwiderstände R1, R2 zur Masse GND fließt.

Die beiden Kondensatoren C1, C2 sind über einen Schalter S1 und einen Referenzwiderstand Rref mit einem Punkt zwischen dem ersten Messwiderstand und dem zweiten Messwiderstand verbunden. An diesem Punkt sind auch die beiden Spannungsmesser U1, U2 angeschlossen. Über dem Referenzwiderstand Rref ist ein weiterer Spannungsmesser Uref angeordnet, welcher eine über dem Referenzwiderstand Rref bei durchfließendem Kalibrierstrom Iref abfallende Spannung misst.

Durch Schließen des Schalters S1 wird somit zusätzlich zum Laststrom Iload ein Kalibrierstrom Iref in das aus den Messwiderständen R1, R2 bestehende Widerstandsnetzwerk eingespeist, wobei sich der erste Kondensator C1 im Wesentlichen über den ersten Messwiderstand R1 entlädt, und der zweite Kondensator C2 sich im Wesentlichen über den zweiten Messwiderstand R2 entlädt. Hierdurch entstehen folglich zwei Kalibrierteilströme, nämlich ein erster Kalibrierteilstrom Iref,1 und ein zweiter Kalibrierteilstrom Iref,2, wobei der erste Kalibrierteilstrom Iref,1 durch den ersten Messwiderstand R1 fließt und der zweite Kalibrierteilstrom Iref,2 durch den zweiten Messwiderstand R2 fließt. Die beiden Kalibrierteilströme Iref,1 und Iref,2 tragen über den beiden Messwiderständen R1, R2 entgegengesetzte Vorzeichen, während ihre Summe Iref durch den Referenzwiderstand Rref fließt und wie bereits beschrieben über eine Spannungsmessung gemessen werden kann.

Die Spannungsmesser U1, U2 zur Messung der über den beiden Messwiderständen R1, R2 abfallenden Spannungen sind vorliegend nicht weiter im Detail ausgeführt. Die Spannungsmesser U1, U2 weisen typischerweise jeweils mindestens einen Verstärker auf, in der Regel mit variablem Verstärkungsfaktor, und je einen Anlog-Digital-Wandler oder auch einen gemeinsamen Analog-Digital-Wandler, welcher über einen Multiplexer je einem Verstärker zugeschaltet werden kann.

In Figur 1 nicht eingezeichnet ist ein Rechenwerk, beispielsweise eine elektronische Steuerungsvorrichtung, welche beispielsweise als Mikrocontroller ausgebildet sein kann. Eine solche elektronische Steuerungsvorrichtung kann beispielsweise Prozessormittel und Speichermittel aufweisen, wobei in den Speichermitteln Programmcode gespeichert ist, bei dessen Ausführung die Prozessormittel ein erfindungsgemäßes Verfahren ausführen. Insbesondere können die Prozessormittel dabei den Laststrom Iload gemäß den oben genannten Formeln berechnen. Das Rechenwerk bzw. die elektronische Steuerungsvorrichtung kann bevorzugt auch eine Schnittstelle zum Einlesen der Spannungen U1, U2, Uref sowie eine Schnittstelle zum Steuern des Schalters S1 aufweisen.

Es sei erwähnt, dass anstelle der Kondensatoren C1, C2 jede beliebige andere Art von Stromquelle zum Einsatz kommen kann. Beispielsweise können DC/DC-Wandler, eine direkte Verbindung zum Pluspol einer Batterie (mit oder ohne Vorwiderstand Rlim), Längsregler, geregelte Präzisionsstromquellen (insbesondere mit Entfall der Iref-Messung über Rref) oder auch andere geeignete Ausführungen zum Einsatz kommen.

Es sei des Weiteren darauf hingewiesen, dass Teile der Berechnungen, insbesondere die Berechnung einer Summe von über den Messwiderständen gemessenen Spannungen (Un, Um) und/oder eine Differenz dieser Spannungen (Un-Um) auch vor der Digitalisierung der Messwerte analog ausgeführt werden können.

Figur 2 zeigt eine Messwiderstandsgruppe mit Beschaltung gemäß einem zweiten Ausführungsbeispiel. Es sei erwähnt, dass bei Figur 2 und den weiteren Figuren im Wesentlichen auf die Änderungen zu den vorherigen Figuren eingegangen wird, wobei bezüglich nicht eigens erwähnter Elemente auf die vorherige Beschreibung verwiesen sei.

Bei der Ausführung gemäß Figur 2 besteht das Widerstandsnetzwerk bzw. die Messwiderstandsgruppe aus mehreren, parallel bzw. in Reihe geschalteten Messwiderständen R1, R2, R3, R4,..., Rz, Rz-1. Ein Vorteil dieser Ausführung besteht insbesondere darin, dass durch die Parallelschaltung mehrerer Widerstandszweige ein insgesamt niedrigerer Messwiderstand im Iload-Pfad erreicht wird, während die Messwiderstände R1, R2,..., Rz-1, Rz relativ groß sein können. Damit wird selbst bei niedrigem angelegtem Kalibrierstrom im Vergleich zum Laststrom ein relativ hoher, d.h.

leicht messbarer Spannungsabfall, am jeweiligen Messwiderstand erzeugt. Über den Multiplexer Mux können die Kalibrierströme Iref und die Spannungsmesser Un, Um einem beliebigen Zweig (R1, R2), (R3, R4),..., (Rz-1, Rz) zugeordnet werden.

Es kann vorteilhaft sein, anstelle des Multiplexers zum gemeinsamen Schalten der Referenzströme und der Messgröße zwei oder mehrere Multiplexer einzusetzen, wovon einer zum Schalten der Referenzströme und ein zweiter zum Schalten der Spannungsmesser auf den jeweiligen Zweig des Widerstandsnetzwerks verwendet wird.

Anstelle des Multiplexers Mux kann beispielsweise auch je eine Stromquelle und/oder je ein Spannungsmessgerät pro Messwiderstand R1, R2,..., Rz-1, Rz verwendet werden.

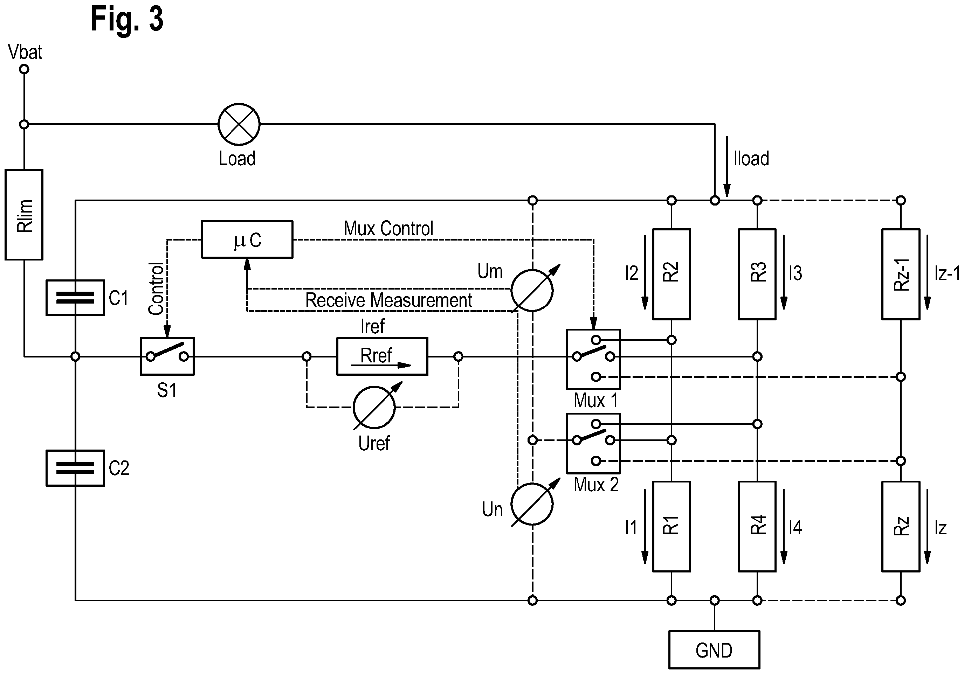

Figur 3 zeigt eine Messwiderstandsgruppe mit Beschaltung gemäß einem dritten Ausführungsbeispiel der Erfindung. Dabei wird ein separater Multiplexer Mux1 zum Schalten des Kalibrierstroms Iref auf einen beliebigen Zweig (R1, R2), (R3, R4),..., (Rz-1, Rz) des Widerstandsnetzwerks und ein zweiter Multiplexer Mux2 zum Schalten der Spannungsmesser Un, Um auf einen beliebigen Zweig (R1, R2), (R3, R4),..., (Rz-1, Rz) des Widerstandsnetzwerks verwendet. Ein Mikrocontroller µC steuert die Multiplexer Mux1, Mux2 und den Schalter S1 und empfängt die Messwerte Un, Um, Uref.

Der Mikrocontroller µC ist eine elektronische Steuerungsvorrichtung und ist dazu konfiguriert, ein erfindungsgemäßes Verfahren auszuführen. Dabei kann grundsätzlich auf alle beschriebenen Ausführungen und Varianten zurückgegriffen werden.

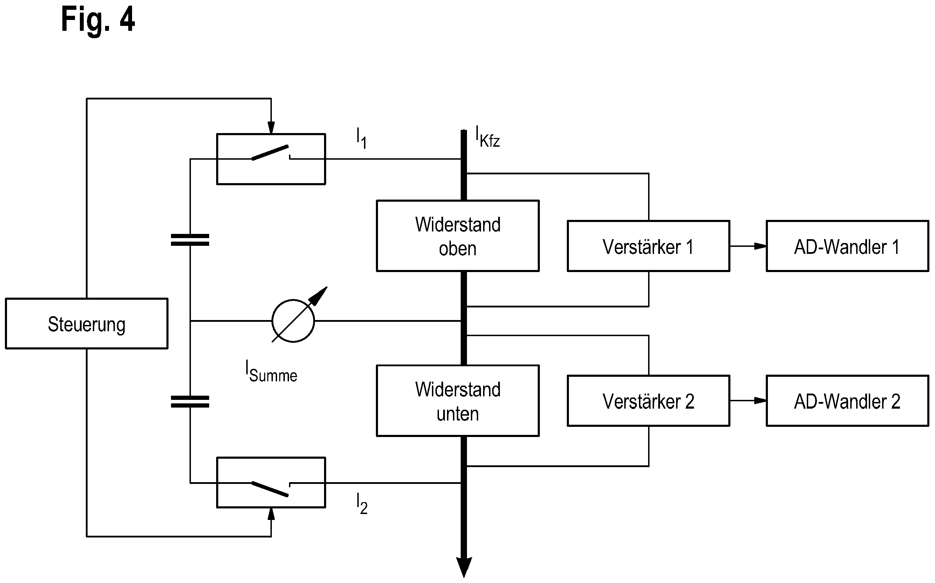

Figur 4 zeigt eine Messwiderstandsgruppe mit Beschaltung gemäß einem vierten Ausführungsbeispiel der Erfindung, bei welcher die Kalibrierströme ISumme von der Steuerung gezielt über verschiedene Messwiderstände (Widerstand oben, Widerstand unten) eines Widerstandszweigs getrennt geschaltet werden können. Die Spannungsmessung ist detailliert in die Schritte Verstärkung (Verstärker 1, Verstärker 2) und Analog-Digital-Wandlung (AD-Wandler 1, AD-Wandler 2) aufgeteilt.

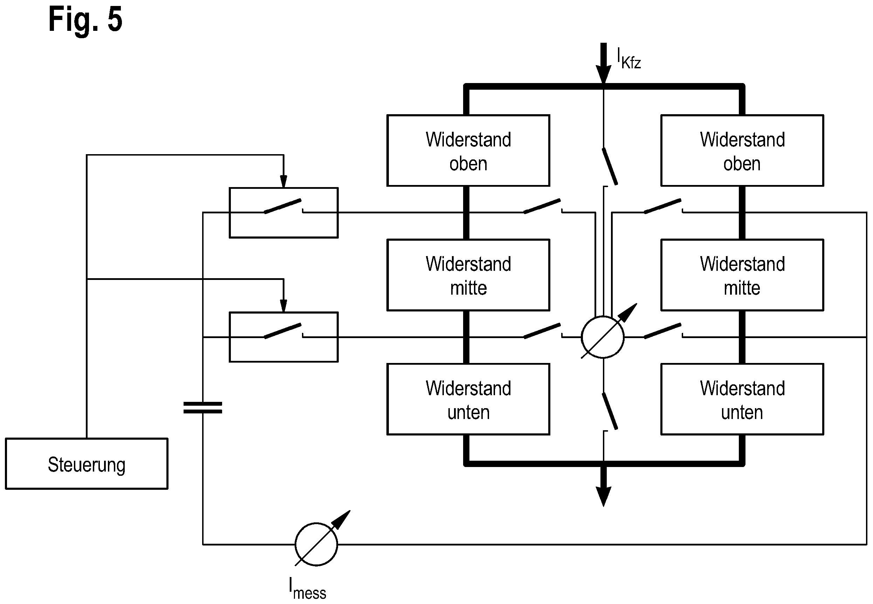

Figur 5 zeigt eine Messwiderstandsgruppe mit Beschaltung gemäß einem fünften Ausführungsbeispiel, bei dem das Widerstandsnetzwerk drei in Reihe geschaltete Widerstände (Widerstand oben, Widerstand Mitte, Widerstand unten) je Zweig enthält, die separat mit dem Kalibrierstrom beaufschlagt werden können.

Beliebige Teilmengen der gezeigten Schaltungen können beispielsweise diskret auf einer Leiterplatte bestückt werden oder in einem Halbleiterbaustein integriert werden. Zusätzlich kann die diskrete Schaltung oder der Halbleiterbaustein weitere Vorrichtungen, beispielsweise Temperatursensoren, insbesondere zur Temperaturmessung, mindestens einen der Widerstände Rref, R1, R2,..., Rn, Spannungssensoren, insbesondere zur Messung von Batteriespannungen, Kommunikationsschnittstellen, Vorrichtungen zur Regelung der Stromquellen C1, C2, weitere Stromquellen, Taktgeber, flüchtige und/oder nichtflüchtige Datenspeicher, insbesondere zur Speicherung von Kalibrierdaten der Strommessvorrichtung, beispielsweise ein im Fertigungs-Endtest ermittelter Wert von Rref oder ein Temperaturkoeffizient von Rref, Mikroprozessoren, insbesondere zur Berechnung von physikalischen Größen der Batterie oder zur Berechnung von Temperaturmodellen, insbesondere zur Berechnung der Batterietemperatur, der Umgebungstemperatur der Vorrichtung oder zur Berechnung einer Temperatur eines oder mehrerer der verwendeten Widerstände Rref, R1,..., Rz aufweisen.

Die gesamte Anordnung oder eine beliebige Teilmenge der Vorrichtung kann beispielsweise in ein Kunststoff- oder Metallgehäuse mit oder ohne integriertem Stecker eingebaut werden, oder kann mit einem Kunststoff umspritzt werden.

Die gesamte Anordnung oder eine beliebige Teilmenge der genannten Vorrichtungen, insbesondere die Messwiderstände bzw. Shunt-Widerstände R1,..., Rz können in eine Batterie-Polklemme, in einen Kabelschuh, in ein Batteriekabel oder in eine Batterie integriert werden.

Die Schaltung kann darüber hinaus einen oder mehrere Chopper für die an den Widerständen Rref, R1,..., Rz abgegriffenen Spannungen enthalten.

Die Schaltung kann darüber hinaus ein oder mehrere Sample-and-Hold-Glieder für an den Widerständen Rref, R1,..., Rz abgegriffene Spannungen oder dort abgegriffene oder verstärkte Spannungen enthalten.

Letztendlich kann die Messung des Kalibrierstroms Iref auch mit einem anderen Strommessverfahren als einer Spannungsmessung über Iref durchgeführt werden, beispielsweise mit einem Hall-Sensor oder anderen Magnet-basierten Messmethoden.

Nachfolgend sei noch eine Herleitung für die oben genannten Formeln gegeben. Bezüglich der Bedeutung der einzelnen Variablen sei auf die obige Beschreibung verwiesen.

$$\left| I_{ref,1} \right| + \left| I_{ref,2} \right| = I_{ref}$$

$$I1 = I_{load} + \left| I_{ref,1} \right|$$

$$I2 = I_{load} - \left| I_{ref,2} \right|$$

$$U1 = R1 * g_1 * \left( I_{load} + \left| I_{ref,1} \right| \right)$$

$$U2 = R2 * g_2 * \left( I_{load} - \left| I_{ref,2} \right| \right)$$

$$a * R1 * g_1 = R2 * g_2$$

$$U2 = a * R1 * g_1 * \left( I_{load} - \left| I_{ref,2} \right| \right)$$

$$U1 - \frac{1}{a} * U2 = R1 * g_1 * \left( \left| I_{ref,1} \right| + \left| I_{ref,2} \right| \right)$$

$$R1 * g_1 = \frac{U1 - \dfrac{1}{a} * U2}{I_{ref}}$$

$$R2 * g_2 = a * R1 * g_1$$

Erwähnte Schritte des erfindungsgemäßen Verfahrens können in der angegebenen Reihenfolge ausgeführt werden. Sie können jedoch auch in einer anderen Reihenfolge ausgeführt werden. Das erfindungsgemäße Verfahren kann in einer seiner Ausführungen, beispielsweise mit einer bestimmten Zusammenstellung von Schritten, in der Weise ausgeführt werden dass keine weiteren Schritte ausgeführt werden.

Zum Zweck der besseren Lesbarkeit werden in den Ansprüchen einige Bezugszeichen verkürzt wiedergegeben. So wird der erste Betriebsparameter mit a bezeichnet, der zweite Betriebsparameter wird mit R*g bezeichnet und der Verstärkungsfaktor wird mit g bezeichnet. Auf die in der obigen Beschreibung verwendeten Indizes wurde dabei verzichtet.

**Patentansprüche**

1. Verfahren zum Bestimmen eines durch eine Messwiderstandsgruppe fließenden Laststroms (Iload),

   - wobei die Messwiderstandsgruppe eine Anzahl von Zweigen aufweist und jeder Zweig zumindest einen jeweiligen ersten Messwiderstand (R1) und einen jeweiligen zweiten Messwiderstand (R2) aufweist,
   - wobei das Verfahren für jeden der Zweige folgende Schritte aufweist:

       - Messen einer ersten Messspannung (U1), welche über dem ersten Messwiderstand (R1) abfällt und einer zweiten Messspannung (U2), welche über dem zweiten Messwiderstand (R2) abfällt,
       - Berechnen eines ersten Betriebsparameters (a) basierend auf der ersten Messspannung (U1) und der zweiten Messspannung (U2),
       - Berechnen des Laststroms (Iload) basierend zumindest auf der zweiten Messspannung (U2) und einem zweiten Betriebsparameter (R*g),

   - wobei das Verfahren ausschließlich während jeweiliger Kalibrierzeiträume folgende Schritte aufweist:

       - Leiten eines Kalibrierstroms (Iref) in den Zweig der Messwiderstandsgruppe , wobei sich der Kalibrierstrom (Iref) in einen durch den ersten Messwiderstand (R1) fließenden ersten Kalibrierteilstrom (Iref,1) und einen durch den zweiten Messwiderstand (R2) fließenden zweiten Kalibrierteilstrom (Iref,2) aufteilt, und

- Messen einer ersten Kalibrierspannung (U1), welche bei fließendem Kalibrierstrom (Iref) und Laststrom (Iload) über dem ersten Messwiderstand (R1) abfällt, und einer zweiten Kalibrierspannung (U2), welche bei fließendem Kalibrierstrom (Iref) und Laststrom (Iload) über dem zweiten Messwiderstand (R2) abfällt,
- wobei basierend zumindest auf der ersten Kalibrierspannung (U1), der zweiten Kalibrierspannung (U2), dem ersten Betriebsparameter (a) und einer Stromstärke des Kalibrierstroms (Iref) der zweite Betriebsparameter (R*g) berechnet wird.

2. Verfahren nach Anspruch 1,

- wobei bezogen auf eine Stromrichtung des Laststroms (Iload) der erste Kalibrierteilstrom (Iref,1) unterschiedlich, insbesondere gegengleich zum zweiten Kalibrierteilstrom (Iref,2) ist.

3. Verfahren nach einem der vorhergehenden Ansprüche,

- wobei der erste Kalibrierteilstrom (Iref,1) Null ist.

4. Verfahren nach einem der vorhergehenden Ansprüche,

- wobei der zweite Betriebsparameter (R*g) einem Produkt aus einem Widerstandswert des zweiten Messwiderstands (R1) und einem Verstärkungsfaktor (g) eines die zweite Messspannung messenden Spannungsmessers (U2) entspricht.

5. Verfahren nach einem der vorhergehenden Ansprüche,

- wobei der zweite Betriebsparameter (R*g) als Differenz zwischen einem ersten Bruch und einem zweiten Bruch berechnet wird,
- wobei im Zähler des ersten Bruchs die zweite Referenzspannung (U2) steht,
- wobei im Nenner des ersten Bruchs die Stromstärke (Iref) des Kalibrierstroms steht,
- wobei im Zähler des zweiten Bruchs die erste Referenzspannung (U1) steht, und
- wobei im Nenner des zweiten Bruchs ein Produkt aus dem ersten Betriebsparameter (a) und der Stromstärke des Kalibrierstroms (Iref) steht.

6. Verfahren nach einem der vorhergehenden Ansprüche,

- wobei der erste Betriebsparameter (a) einem Verhältnis zwischen
- einem Produkt aus Widerstandswert des zweiten Messwiderstands (R2) und Verstärkungsfaktor (g) eines die zweite Messspannung messenden Spannungsmessers (U2), und
- einem Produkt aus Widerstandswert des ersten Messwiderstands (R1) und Verstärkungsfaktor (g) eines die erste Messspannung messenden Spannungsmessers (U1) entspricht.

7. Verfahren nach einem der vorhergehenden Ansprüche,

- wobei der erste Betriebsparameter (a) durch Division der ersten Messspannung (U1) durch die zweite Messspannung (U2) oder durch Regressionsanalyse basierend auf der ersten Messspannung (U1) und der zweiten Messspannung (U2) berechnet wird.

8. Verfahren nach einem der vorhergehenden Ansprüche,

- wobei der Laststrom (Iload) während jeweiliger Kalibrierzeiträume durch Extrapolation von Lastströmen aus Zeiten außerhalb von Kalibrierzeiträumen berechnet wird.

9. Verfahren nach einem der vorhergehenden Ansprüche,

- wobei der erste Kalibrierteilstrom (Iref,1) Null ist, und
- wobei der Laststrom (Iload) während jeweiliger Kalibrierzeiträume basierend auf der zweiten Kalibrierspannung (U2), dem zweiten Betriebsparameter (R*g) und der Stromstärke des Kalibrierstroms (Iref) berechnet wird.

10. Verfahren nach einem der vorhergehenden Ansprüche,

- wobei der Laststrom (Iload) außerhalb von Kalibrierzeiträumen durch Division der zweiten Messspannung (U2) durch den zweiten Betriebsparameter (U1) berechnet wird,
und/oder
- wobei der Laststrom (Iload) während Kalibrierzeiträumen durch Division der zweiten Kalibrierspannung (U2) durch den zweiten Betriebsparameter (U1) abzüglich eines Korrekturwerts berechnet wird, wobei der Korrekturwert vorzugsweise die Stromstärke des Kalibrierstroms (Iref) ist, insbesondere wenn der erste Kalibrierteilstrom (Iref,1) Null ist.

11. Verfahren nach einem der vorhergehenden Ansprüche,

- wobei die Stromstärke des Kalibrierstroms (Iref) basierend auf einem gemessenen Spannungsabfall an einem Referenzwiderstand (Rref), insbesondere einem temperatur- und/oder langzeitstabilen Referenzwiderstand (Rref), mit bekanntem Widerstandswert ermittelt wird.

12. Verfahren nach Anspruch 11,

- wobei basierend auf der Stromstärke des Referenzwiderstands (Rref) ein Fehlerwert für den Laststrom berechnet wird.

13. Batteriesensor, aufweisend

- eine Messwiderstandsgruppe , wobei die Messwiderstandsgruppe eine Anzahl von Zweigen aufweist und jeder Zweig zumindest einen jeweiligen ersten Messwiderstand (R1) und einen jeweiligen zweiten Messwiderstand (R2) aufweist,
- zumindest einen ersten Spannungsmesser (U1) und einen zweiten Spannungsmesser (U2), wobei der erste Spannungsmesser (U1) zur Messung einer über dem ersten Messwiderstand (R1) abfallenden Spannung konfiguriert ist und der zweite Spannungsmesser (U2) zur Messung einer über dem zweiten Messwiderstand abfallenden Spannung konfiguriert ist,
- zumindest eine Kalibrierstromquelle, welche zum Durchleiten eines Kalibrierstroms (Iref) durch die Messwiderstandsgruppe konfiguriert ist, und
- eine elektronische Steuerungsvorrichtung (mC), welche dazu konfiguriert ist, ein Verfahren nach einem der vorhergehenden Ansprüche durchzuführen.

14. Verfahren nach einem der Ansprüche 1 bis 12 oder Batteriesensor nach Anspruch 13,

- wobei die Messwiderstandsgruppe einen einzigen Zweig aufweist;
oder
- wobei die Messwiderstandsgruppe eine Mehrzahl von Zweigen aufweist,
- wobei eine Anzahl von Multiplexern (Mux) vorgesehen sind, um eine Spannungsmessung und/oder ein Durchleiten des Kalibrierstroms (Iref) einem bestimmten Zweig zuzuordnen.

15. Verfahren nach einem der Ansprüche 1 bis 12 oder 14 oder Batteriesensor nach einem der Ansprüche 13 oder 14,

- wobei die Messwiderstandsgruppe eine Mehrzahl von Zweigen aufweist, und
- wobei der Laststrom (Iload) summiert über alle Zweige berechnet wird.

**Claims**

1. Method for determining a load current (Iload) flowing through a group of measuring resistors,

- wherein the group of measuring resistors has a number of branches and each branch has at least one respective first measuring resistor (R1) and one respective second measuring resistor (R2),
- wherein the method has the following steps for each of the branches:

- measuring a first measurement voltage (U1), which is dropped across the first measuring resistor (R1), and a second measurement voltage (U2), which is dropped across the second measuring resistor (R2),
- calculating a first operating parameter (a) on the basis of the first measurement voltage (U1) and the second measurement voltage (U2),
- calculating the load current (Iload) on the basis of at least the second measurement voltage (U2) and a second operating parameter (R*g),

- wherein the method has the following steps solely during respective calibration periods:

- conducting a calibration current (Iref) into the branch of the group of measuring resistors, wherein the calibration current (Iref) is divided into a first calibration partial current (Iref,1) flowing through the first measuring resistor (R1) and a second calibration partial current (Iref,2) flowing through the second measuring resistor (R2), and
- measuring a first calibration voltage (U1), which is dropped across the first measuring resistor (R1) in the case of a flowing calibration current (Iref) and load current (Iload), and a second calibration voltage (U2), which is dropped across the second measuring resistor (R2) in the case of a flowing calibration current (Iref) and load current (Iload),
- wherein the second operating parameter (R*g) is calculated on the basis of at least the first calibration voltage (U1), the second calibration voltage (U2), the first operating parameter (a) and a current intensity of the calibration current (Iref).

2. Method according to Claim 1,

- wherein the first calibration partial current (Iref, 1) is different to, in particular opposite, the second calibration partial current (Iref,2) based on a current direction of the load current (Iload).

3. Method according to one of the preceding claims,

- wherein the first calibration partial current (Iref, 1) is zero.

4. Method according to one of the preceding claims,

- wherein the second operating parameter (R*g) corresponds to a product of a resistance value of the second measuring resistor (R1) and a gain factor (g) of a voltmeter (U2) measuring the second measurement voltage.

5. Method according to one of the preceding claims,

- wherein the second operating parameter (R*g) is calculated as the difference between a first fraction and a second fraction,
- wherein the numerator of the first fraction contains the second reference voltage (U2),
- wherein the denominator of the first fraction contains the current intensity (Iref) of the calibration current,
- wherein the numerator of the second fraction contains the first reference voltage (U1), and
- wherein the denominator of the second fraction contains a product of the first operating parameter (a) and the current intensity of the calibration current (Iref).

6. Method according to one of the preceding claims,

- wherein the first operating parameter (a) corresponds to a ratio between
- a product of the resistance value of the second measuring resistor (R2) and the gain factor (g) of a voltmeter (U2) measuring the second measurement voltage, and
- a product of the resistance value of the first measuring resistor (R1) and the gain factor (g) of a voltmeter (U1) measuring the first measurement voltage.

7. Method according to one of the preceding claims,

- wherein the first operating parameter (a) is calculated by dividing the first measurement voltage (U1) by the second measurement voltage (U2) or by means of a regression analysis on the basis of the first measurement voltage (U1) and the second measurement voltage (U2).

8. Method according to one of the preceding claims,

- wherein the load current (Iload) is calculated during respective calibration periods by extrapolating load currents from times outside calibration periods.

**9.** Method according to one of the preceding claims,

- wherein the first calibration partial current (Iref,1) is zero, and
- wherein the load current (Iload) is calculated during respective calibration periods on the basis of the second calibration voltage (U2), the second operating parameter (R*g) and the current intensity of the calibration current (Iref).

**10.** Method according to one of the preceding claims,

- wherein the load current (Iload) is calculated outside calibration periods by dividing the second measurement voltage (U2) by the second operating parameter (U1), and/or
- wherein the load current (Iload) is calculated during calibration periods by dividing the second calibration voltage (U2) by the second operating parameter (U1) minus a correction value, wherein the correction value is preferably the current intensity of the calibration current (Iref), in particular if the first calibration partial current (Iref, 1) is zero.

**11.** Method according to one of the preceding claims,

- wherein the current intensity of the calibration current (Iref) is determined on the basis of a measured voltage drop at a reference resistor (Rref), in particular a temperature-stable and/or long-term stable reference resistor (Rref), with a known resistance value.

**12.** Method according to Claim 11,

- wherein an error value for the load current is calculated on the basis of the current intensity of the reference resistor (Rref).

**13.** Battery sensor, having

- a group of measuring resistors, wherein the group of measuring resistors has a number of branches and each branch has at least one respective first measuring resistor (R1) and one respective second measuring resistor (R2),
- at least one first voltmeter (U1) and one second voltmeter (U2), wherein the first voltmeter (U1) is configured to measure a voltage dropped across the first measuring resistor (R1), and the second voltmeter (U2) is configured to measure a voltage dropped across the second measuring resistor,
- at least one calibration current source which is configured to conduct a calibration current (Iref) through the group of measuring resistors, and
- an electronic control apparatus (mC) which is configured to carry out a method according to one of the preceding claims.

**14.** Method according to one of Claims 1 to 12 or battery sensor according to Claim 13,

- wherein the group of measuring resistors has a single branch;
or
- wherein the group of measuring resistors has a plurality of branches,
- wherein a number of multiplexers (Mux) are provided in order to assign a voltage measurement and/or conduction of the calibration current (Iref) to a particular branch.

**15.** Method according to one of Claims 1 to 12 or 14 or battery sensor according to either of Claims 13 and 14,

- wherein the group of measuring resistors has a plurality of branches, and
- wherein the load current (Iload) is calculated in a manner summed over all branches.

**Revendications**

1. Procédé pour déterminer un courant de charge (Iload) qui circule à travers un groupe de résistances de mesure,

- le groupe de résistances de mesure possédant un certain nombre de branches et chaque branche possédant au moins une première résistance de mesure (R1) respective et une deuxième résistance de mesure (R2) respective,
- le procédé comprenant les étapes suivantes pour chacune des branches :

  - mesure d'une première tension de mesure (U1), laquelle chute aux bornes de la première résistance de mesure (R1) et d'une deuxième tension de mesure (U2), laquelle chute aux bornes de la deuxième résistance de mesure (R2),
  - calcul d'un premier paramètre de fonctionnement (a) en se basant sur la première tension de mesure (U1) et la deuxième tension de mesure (U2),
  - calcul du courant de charge (Iload) en se basant au moins sur la deuxième tension de mesure (U2) et un deuxième paramètre de fonctionnement (R*g),

- le procédé comprenant les étapes suivantes exclusivement pendant des périodes d'étalonnage respectives :

  - conduite d'un courant d'étalonnage (Iref) dans la branche du groupe de résistances de mesure, le courant d'étalonnage (Iref) se divisant en un premier courant partiel d'étalonnage (Iref,1) circulant à travers la première résistance de mesure (R1) et un deuxième courant partiel d'étalonnage (Iref,2) circulant à travers la deuxième résistance de mesure (R2), et
  - mesure d'une première tension d'étalonnage (U1), laquelle chute aux bornes de la première résistance de mesure (R1) lors de la circulation du courant d'étalonnage (Iref) et du courant de charge (Iload), et d'une deuxième tension d'étalonnage (U2), laquelle chute aux bornes de la deuxième résistance de mesure (R2) lors de la circulation du courant d'étalonnage (Iref) et du courant de charge (Iload),
  - le deuxième paramètre de fonctionnement (R*g) étant calculé en se basant au moins sur la première tension d'étalonnage (U1), la deuxième tension d'étalonnage (U2), le premier paramètre de fonctionnement (a) et une intensité de courant du courant d'étalonnage (Iref).

2. Procédé selon la revendication 1,

- le premier courant partiel d'étalonnage (Iref,1) étant différent, notamment inversé par rapport au deuxième courant partiel d'étalonnage (Iref,2), en référence à une direction de courant du courant de charge (Iload).

3. Procédé selon l'une des revendications précédentes,

- le premier courant partiel d'étalonnage (Iref,1) étant nul.

4. Procédé selon l'une des revendications précédentes,

- le deuxième paramètre de fonctionnement (R*g) correspondant à un produit d'une valeur de résistance de la deuxième résistance de mesure (R1) par un facteur de gain (g) d'un voltmètre (U2) qui mesure la deuxième tension de mesure.

5. Procédé selon l'une des revendications précédentes,

- le deuxième paramètre de fonctionnement (R*g) étant calculé en tant que différence entre une première fraction et une deuxième fraction,
- la deuxième tension de référence (U2) se trouvant dans le numérateur de la première fraction,
- l'intensité de courant du courant d'étalonnage (Iref) se trouvant dans le dénominateur de la première fraction,
- la première tension de référence (U1) se trouvant dans le numérateur de la deuxième fraction,
- un produit du premier paramètre de fonctionnement (a) et de l'intensité de courant du courant d'étalonnage (Iref) se trouvant dans le dénominateur de la deuxième fraction.

6. Procédé selon l'une des revendications précédentes,

- le premier paramètre de fonctionnement (a) correspondant à un rapport entre
- un produit de la valeur de résistance de la deuxième résistance de mesure (R2) et du facteur de gain (g) d'un voltmètre (U2) qui mesure la deuxième tension de mesure, et
- un produit de la valeur de résistance de la première résistance de mesure (R1) et du facteur de gain (g) d'un voltmètre (U1) qui mesure la première tension de mesure.

7. Procédé selon l'une des revendications précédentes,

- le premier paramètre de fonctionnement (a) étant calculé par division de la première tension de mesure (U1) par la deuxième tension de mesure (U2) ou par une analyse de régression se basant sur la première tension de mesure (U1) et la deuxième tension de mesure (U2).

8. Procédé selon l'une des revendications précédentes,

- le courant de charge (Iload) étant calculé pendant les périodes d'étalonnage respectives par extrapolation des courants de charge de temps en dehors des périodes d'étalonnage.

9. Procédé selon l'une des revendications précédentes,

- le premier courant partiel d'étalonnage (Iref,1) étant nul, et
- le courant de charge (Iload) étant calculé pendant les périodes d'étalonnage respectives en se basant sur la deuxième tension d'étalonnage (U2), le deuxième paramètre de fonctionnement (R*g) et l'intensité de courant du courant d'étalonnage (Iref).

10. Procédé selon l'une des revendications précédentes,

- le courant de charge (Iload) étant calculé en dehors des périodes d'étalonnage par division de la deuxième tension de mesure (U2) par le deuxième paramètre de fonctionnement (U1),
et/ou
- le courant de charge (Iload) étant calculé pendant les périodes d'étalonnage par division de la deuxième tension de mesure (U2) par le deuxième paramètre de fonctionnement (U1) moins une valeur de correction, la valeur de correction étant de préférence l'intensité de courant du courant d'étalonnage (Iref), notamment lorsque le premier courant partiel d'étalonnage (Iref,1) est nul.

11. Procédé selon l'une des revendications précédentes,

- l'intensité de courant du courant d'étalonnage (Iref) étant déterminée en se basant sur une chute de tension mesurée aux bornes d'une résistance de référence (Rref), notamment d'une résistance de référence (Rref) stable en température et/ou à long terme, ayant une valeur de résistance connue.

12. Procédé selon la revendication 11,

- une valeur d'erreur étant calculée pour le courant de charge en se basant sur l'intensité de courant de la résistance de référence (Rref).

13. Capteur pour batterie, possédant

- un groupe de résistances de mesure, le groupe de résistances de mesure possédant un certain nombre de branches et chaque branche possédant au moins une première résistance de mesure (R1) respective et une deuxième résistance de mesure (R2) respective,
- au moins un premier voltmètre (U1) et un deuxième voltmètre (U2), le premier voltmètre (U1) étant configuré pour mesurer une tension qui chute aux bornes de la première résistance de mesure (R1) et le deuxième voltmètre (U2) étant configuré pour mesurer une tension qui chute aux bornes de la deuxième résistance de mesure,
- au moins une source de courant d'étalonnage, laquelle est configurée pour faire passer un courant d'étalonnage (Iref) à travers le groupe de résistances de mesure, et
- un dispositif de commande électronique (mC), lequel est configuré pour mettre en oeuvre un procédé selon l'une des revendications précédentes.

**14.** Procédé selon l'une des revendications 1 à 12 ou capteur pour batterie selon la revendication 13,

- le groupe de résistances de mesure possédant une branche unique ;
ou
- le groupe de résistances de mesure possédant une pluralité de branches,
- un certain nombre de multiplexeurs (Mux) étant présents afin d'affecter une mesure de tension et/ou une circulation du courant d'étalonnage (Iref) à une branche déterminée.

**15.** Procédé selon l'une des revendications 1 à 12 ou 14 ou capteur pour batterie selon l'une des revendications 13 ou 14,

- le groupe de résistances de mesure possédant une pluralité de branches, et
- le courant de charge (Iload) étant calculé totalisé sur toutes les branches.

Fig. 1

Fig. 2

EP 3 449 264 B1

Fig. 3

EP 3 449 264 B1

Fig. 4

EP 3 449 264 B1

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2014191768 A